# EUROPEAN PATENT APPLICATION

(11) **EP 4 254 552 A1**
(43) Date of publication of application: **04.10.2023**
(21) Application number: 21903808.0
(22) Date of filing: 07.12.2021
(51) Int. Cl.: H01M 4/36, H01M 4/525, H01M 4/505, H01M 4/62, H01M 10/052, C23C 16/44, C23C 16/40, C23C 16/448

(54) **POSITIVE ELECTRODE MATERIAL FOR LITHIUM SECONDARY BATTERY, METHOD FOR MANUFACTURING SAME, AND LITHIUM SECONDARY BATTERY COMPRISING SAME**

(30) Priority: 07.12.2020 KR 20200169236
(71) Applicant: LG Energy Solution, Ltd., Seoul 07335 (KR)
(72) Inventor: CHAE, Seulki, Daejeon 34122 (KR); KIM, Hakyoon, Daejeon 34122 (KR); BAEK, Sora, Daejeon 34122 (KR); HUR, Hyuck, Daejeon 34122 (KR); KIM, Dong Hwi, Daejeon 34122 (KR); KIM, Hyeongil, Daejeon 34122 (KR); JUNG, Wang Mo, Daejeon 34122 (KR); LEE, Donghun, Daejeon 34122 (KR)
(74) Representative: Hoffmann Eitle
(86) International application number: PCT/KR2021/018462
(87) International publication number: WO 2022/124762

(57) **Abstract**

Disclosed is a positive electrode material for a lithium secondary battery capable of improving the problems of resistance and lifetime deterioration of the battery by forming a thin and uniform metal oxide on the surface of the lithium nickel cobalt manganese-based positive electrode active material to suppress side reactions at the interface in contact with the electrolyte during the operation (during charging) of the battery, and thus reducing the generation and accumulation of resistance components including by-products and the rock salt phase, and the desorption of oxygen and the generation of gas in the electrolyte solution, and a method for preparing the same and a lithium secondary battery comprising the same. The method of preparing the positive electrode material for the lithium secondary battery comprises a method of coating a metal oxide on the surface of a lithium nickel cobalt manganese-based positive electrode active material through a chemical vapor deposition comprising a step of placing lithium nickel cobalt manganese-based positive electrode active material in a deposition apparatus and supplying a metal oxide precursor and a carrier gas, wherein the lithium nickel cobalt manganese-based positive electrode active material is stirred during deposition.

## Description

### [Technical Field]

The present application claims the benefits of priorities based on Korean Patent Application No. 10-2020-0169236 filed on December 7, 2020 and Korean Patent Application No. 10-2021-0173834 filed on December 7, 2021, all the contents of which are incorporated herein by reference.

The present invention relates to a positive electrode material for a lithium secondary battery, a preparation method thereof, and a lithium secondary battery comprising the same, and more particularly, to a positive electrode material for a lithium secondary battery capable of improving the problems of resistance and lifetime deterioration of the battery by forming a thin and uniform metal oxide on the surface of the lithium nickel cobalt manganese-based positive electrode active material to suppress side reactions at the interface in contact with the electrolyte during the operation (during charging) of the battery, and thus reducing the generation and accumulation of resistance components including by-products and the rock salt phase, and the desorption of oxygen and the generation of gas in the electrolyte solution, and a method for preparing the same and a lithium secondary battery comprising the same.

### [Background Art]

Recently, with the rapid spread of electronic devices using batteries such as mobile phones, notebook computers, and electric vehicles, there is a rapid increase in demand for secondary batteries that are small and light and have relatively high capacity. In particular, the lithium secondary battery is light-weight and has high energy density, and thus it has been in the spotlight as a power source for the operation of portable devices. Accordingly, efforts on research and development to improve the performance of the lithium secondary battery are being actively conducted.

This lithium secondary battery produces electrical energy through oxidation and reduction reactions, when lithium ions are intercalated/de-intercalated at the positive electrode and the negative electrode, in a state where an organic electrolyte solution or a polymer electrolyte solution is charged between the positive electrode and the negative electrode made of an active material capable of intercalating and de-intercalating lithium ions.

As a positive electrode active material for the lithium secondary battery, lithium cobalt oxide (LiCoO₂), lithium nickel oxide (LiNiO₂), lithium manganese oxide (LiMnO₂, LiMn₂O₄, etc.), lithium iron phosphate compound (LiFePO₄), etc. have been used. Among them, lithium cobalt oxide (LiCoO₂) is widely used because of its high operating voltage and excellent capacity characteristics, and is being applied as a positive electrode active material for high voltage. However, lithium cobalt oxide (LiCoO₂) has very poor thermal properties due to destabilization of the crystal structure according to the release of lithium and is expensive, and thus there is a limit to using it in large quantities as a power source in fields such as electric vehicles.

In addition, there is also active research and development on lithium nickel oxide (LiNiO₂), which has a high reversible capacity of about 200 mAh/g and is easy to implement in a large-capacity battery. However, there are problems that it has relatively poor thermal stability compared to lithium cobalt oxide (LiCoO₂), and when an internal short circuit occurs due to external pressure in a charged state, the positive electrode active material itself is decomposed, thereby causing rupture and ignition of the battery.

Accordingly, as a method to improve the low thermal stability while maintaining the excellent reversible capacity of lithium nickel oxide (LiNiO₂), a lithium nickel cobalt manganese-based positive electrode active material (or lithium NCM-based positive electrode active material, or NCM-based lithium composite transition metal oxide, or high Ni content positive electrode material) obtained by substituting a part of nickel (Ni) with cobalt (Co) and manganese (Mn) was developed.

If the lithium nickel cobalt manganese-based positive electrode active material is applied to a battery, there is an advantage that high capacity can be realized. However, there is a problem that during the operation of the battery (during charging), side reactions such as the release of oxygen and oxidation of the electrolyte occur at the interface in contact with the electrolyte, and thus an increase in the resistance of the battery and deterioration of its lifetime are caused by the generation and accumulation of resistance components including by-products and rock salt phase, and the release of oxygen and the generation of gas in the electrolyte solution.

Therefore, there is an urgent need to develop a positive electrode material that can improve the problems of the resistance and the deterioration of the lifetime of the battery by not generating side reactions such as the release of oxygen and oxidation of the electrolyte at the interface in contact with the electrolyte, although the lithium nickel cobalt manganese-based positive electrode active material capable of realizing high capacity is used.

### [Disclosure]

### [Technical Problem]

Therefore, it is an object of the present invention to provide a positive electrode material for a lithium secondary battery capable of improving the problems of resistance and lifetime deterioration of the battery by forming a thin and uniform metal oxide on the surface of the lithium nickel cobalt manganese-based positive electrode active material to suppress side reactions at the interface in contact with the electrolyte during the operation (during charging) of the battery, and thus reducing the generation and accumulation of resistance components including by-products and the rock salt phase, and the desorption of oxygen and the generation of gas in the electrolyte solution, and a method for preparing the same and a lithium secondary battery comprising the same.

### [Technical Solution]

In order to achieve the above object, the present invention provides a method for coating a metal oxide on the surface of a lithium nickel cobalt manganese-based positive electrode active material through chemical vapor deposition, comprising a step of placing lithium nickel cobalt manganese-based positive electrode active material in a deposition apparatus and supplying a metal oxide precursor and a carrier gas, wherein the lithium nickel cobalt manganese-based positive electrode active material is stirred during deposition.

In addition, the present invention provides a positive electrode for a lithium secondary battery comprising a lithium nickel cobalt manganese-based positive electrode active material; and a metal oxide layer coated on a surface of the lithium nickel cobalt manganese-based positive electrode active material.

In addition, the present invention provides a lithium secondary battery which comprises a positive electrode comprising the positive electrode material for the lithium secondary battery; a negative electrode; an electrolyte interposed between the positive electrode and the negative electrode; and a separator.

### [Advantageous Effects]

According to the positive electrode material for the lithium secondary battery according to the present invention, a method for preparing the same, and the lithium secondary battery comprising the same, there is an advantage that the problem of the resistance of the battery and the deterioration of its lifetime can be improved by forming a thin and uniform metal oxide on the surface of the lithium nickel cobalt manganese-based positive electrode active material to suppress side reactions at the interface in contact with the electrolyte during the operation (during charging) of the battery, and thus reducing the generation and accumulation of resistance components including by-products and the rock salt phase, and the desorption of oxygen and the generation of gas in the electrolyte solution.

### [Description of Drawings]

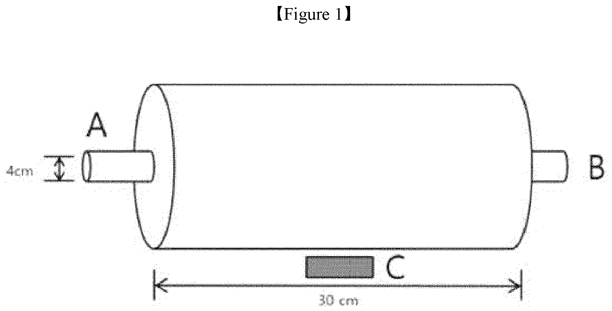

FIG. 1 is a schematic diagram of a deposition apparatus used for preparing the positive electrode material for the lithium secondary battery of the present invention.

### [Best Mode]

Hereinafter, the present invention will be described in detail.

The method for preparing the positive electrode material for the lithium secondary battery according to the present invention provides a method for coating a metal oxide on the surface of a lithium nickel cobalt manganese-based positive electrode active material through chemical vapor deposition, comprising a step of placing lithium nickel cobalt manganese-based positive electrode active material in a deposition apparatus and supplying a metal oxide precursor and a carrier gas, wherein the lithium nickel cobalt manganese-based positive electrode active material is stirred during deposition.

As described above, in order to supplement the problems of lithium transition metal oxides used as a positive electrode material for the existing lithium secondary batteries, such as lithium cobalt oxide (LiCoO₂) and lithium nickel oxide (LiNiO₂), a lithium nickel cobalt manganese-based positive electrode active material (or lithium NCM-based positive electrode active material, or NCM-based lithium composite transition metal oxide, or high Ni-content positive electrode material) has been developed, and it was confirmed that if the lithium nickel cobalt manganese-based positive electrode active material is applied to a battery, a high capacity could be realized.

However, in this case, there is a problem that during the operation of the battery (during charging), side reactions such as the release of oxygen and oxidation of the electrolyte occur at the interface in contact with the electrolyte, and thus an increase in the resistance of the battery and deterioration of the lifetime are caused by the generation and accumulation of resistance components including by-products and rock salt phase, and the release of oxygen and the generation of gas in the electrolyte solution.

Accordingly, the applicant of the present invention has developed a positive electrode material that can improve the problems of the resistance and the deterioration of the lifetime of the battery by not generating side reactions such as the release of oxygen and oxidation of the electrolyte at the interface in contact with the electrolyte, although the lithium nickel cobalt manganese-based positive electrode active material capable of realizing high capacity is used. More specifically, by coating a metal oxide on the surface of the lithium nickel cobalt manganese-based positive electrode active material and at the same time performing this by a chemical vapor deposition (CVD) method, metal oxide is coated thinly and uniformly on the surface of the lithium nickel cobalt manganese-based positive electrode active material. That is, in other words, by thinly and uniformly coating the metal oxide on the surface of lithium nickel cobalt manganese-based positive electrode active material through the chemical vapor deposition method, side reactions such as the release of oxygen and oxidation of the electrolyte at the interface in contact with the electrolyte is minimized.

More specifically, the method of preparing the positive electrode material for the lithium secondary battery according to the present invention comprises a step of placing lithium nickel cobalt manganese-based positive electrode active material in a deposition apparatus and supplying a metal oxide precursor and a carrier gas. The metal oxide precursor is a raw material (i.e., a coating agent) containing metal in the metal oxide to be coated on the surface of the lithium nickel cobalt manganese-based positive electrode active material. As the metal oxide, Al₂O₃, TiO₂, SiO₂, ZrO₂, VO₂, V₂O₅, Nb₂O₅, MgO, TaO₂, Ta₂O₅, B₂O₂, B₄O₃, B₄O₅, ZnO, SnO, HfO₂, Er2O₃, La₂O₃, In₂O₃, Y₂O₃, Ce₂O₃, Sc₂O₃ and W₂O₃ may be exemplified. If the metal oxide comprises aluminum (Al) (e.g., Al₂O₃), trimethyl aluminum (TMA, trimethyl aluminum) may be exemplified.

The carrier gas serves to prevent the metal oxide precursor supplied to the deposition apparatus from being liquefied due to supersaturation, and also to allow the metal oxide as a gaseous phase to react with the surface of the lithium nickel cobalt manganese-based positive electrode active material. Through this, metal oxide can be coated or formed thinly and uniformly on the surface of lithium nickel cobalt manganese-based positive electrode active material. As the carrier gas, inert gases commonly used in the art may be exemplified, and specifically, argon (Ar) gas and nitrogen (N₂) gas may be exemplified, but is not limited thereto.

In addition, by supplying the carrier gas to a deposition apparatus under a certain temperature for a certain time, to which the lithium nickel cobalt manganese-based positive electrode active material and the metal oxide precursor are added, the lithium nickel cobalt manganese-based positive electrode active material and the metal oxide precursor are allowed to react with each other. More specifically, to a deposition apparatus to which the lithium nickel cobalt manganese-based positive electrode active material and the metal oxide precursor are added, the carrier gas may be flowed at a temperature of 25 to 150 °C, preferably 60 to 120 °C, for 10 to 200 minutes, preferably 60 to 120 minutes. If the above conditions are not satisfied, there is a risk that the metal oxide precursor is not vaporized, or the metal oxide is not sufficiently deposited on the surface of the lithium nickel cobalt manganese-based positive electrode active material.

In addition, the lithium nickel cobalt manganese-based positive electrode active material and the metal oxide precursor may be supplied to the deposition apparatus in a weight ratio of 100 to 120 : 1 to 10. If the supply (input) weight ratio of the lithium nickel cobalt manganese-based positive electrode active material and the metal oxide precursor is out of the above range, there may be a problem that the deposition layer is not densely formed.

Meanwhile, while putting the lithium nickel cobalt manganese-based positive electrode active material into the deposition apparatus and supplying the metal oxide precursor and carrier gas (or during deposition), a process of stirring the lithium nickel cobalt manganese-based positive electrode active material should be performed. That is, a stirring process for uniformly contacting the metal oxide precursor (or metal oxide) with the surface of the lithium nickel cobalt manganese-based positive electrode active material should be continuously performed during deposition. If the stirring process is not continuously performed during deposition, the overvoltage of the battery containing the prepared positive electrode material may be increased, thereby reducing the lifetime performance, such as lowering the capacity retention rate.

As such, if stirring is performed while charging the lithium nickel cobalt manganese-based positive electrode active material into the deposition apparatus and supplying the metal oxide precursor and the carrier gas, the gaseous metal oxide reacts with the surface of the lithium nickel cobalt manganese-based positive electrode active material to form a metal oxide coating layer on the surface of the lithium nickel cobalt manganese-based positive electrode active material. Above all, by using the carrier gas and stirring the lithium nickel cobalt manganese-based positive electrode active material, the yield and uniformity of the vapor deposition can be maximized.

Meanwhile, the deposition process may be performed 1 to 4 times in total, preferably 2 to 4 times, more preferably 3 times or 4 times. If the deposition process is performed five or more times, the metal oxide may be coated with an excessive thickness on the surface of the lithium nickel cobalt manganese-based positive electrode active material. In addition, the deposition process should be performed four times or close to four times as much as possible, so that the metal oxide can be coated more thinly and uniformly.

In addition, in the method of preparing the positive electrode material for the lithium secondary battery according to the present invention, it is preferable, in order to prevent the deterioration of the conductivity in the electrode, that the metal oxide is coated only on the surface of the lithium nickel cobalt manganese-based positive electrode active material. Accordingly, it is preferable that the process of preparing the slurry by adding the binder and the electrically conductive material to the positive electrode material for the lithium secondary battery prepared through the above preparation method, and the process of coating and drying the slurry on the current collector be performed separately as much as possible.

Meanwhile, the lithium nickel cobalt manganese-based positive electrode active material can be purchased commercially or prepared according to a preparation method well known in the art. For example, the lithium nickel cobalt manganese-based positive electrode active material can be prepared by adding an ammonium cation-containing complexing agent and a basic compound to a solution of a transition metal including a nickel-containing raw material, a cobalt-containing raw material, and a manganese-containing raw material and co-precipitating them to prepare a nickel-cobalt-manganese precursor, and then mixing the nickel-cobalt-manganese precursor and a lithium raw material and over-calcining them to a temperature of 980 °C or higher.

The nickel-containing raw material may be, for example, nickel-containing acetate, nitrate, sulfate, halide, sulfide, hydroxide, oxide or oxyhydroxide, and specifically may be Ni(OH)₂, NiO, NiOOH, NiCO_{3·}2Ni(OH)_{2·}4H₂O, NiC₂O_{2·}2H₂O, Ni(NO₃)_{2·}6H₂O, NiSO₄, NiSO_{4·}6H₂O, a fatty acid nickel salt, a nickel halide, or a combination thereof, but is not limited thereto. The cobalt-containing raw material may be cobalt-containing acetate, nitrate, sulfate, halide, sulfide, hydroxide, oxide or oxyhydroxide, and the like, and specifically may be Co(OH)₂, CoOOH, Co(OCOCH₃)_{2·}4H₂O, Co(NO₃)_{2·}6H₂O, CoSO₄, Co(SO₄)_{2·}7H₂O, or a combination thereof, but is not limited thereto. The manganese-containing raw material may be, for example, manganese-containing acetate, nitrate, sulfate, halide, sulfide, hydroxide, oxide, oxyhydroxide, or a combination thereof, and specifically may be a manganese oxide such as Mn₂O₃, MnO₂, Mn₃O₄; a manganese salt such as MnCO₃, Mn(NO₃)₂, MnSO₄, manganese acetate, manganese dicarboxylic acid, manganese citrate, or fatty acid manganese salt; manganese oxyhydroxide, manganese chloride, or a combination thereof, but is not limited thereto.

The solution of the transition metal is prepared by adding the nickel-containing raw material, the cobalt-containing raw material and the manganese-containing raw material to a solvent, specifically water, or a mixed solvent of an organic solvent that can be uniformly mixed with water (e.g., alcohol, etc.) and water, or may be prepared by mixing an aqueous solution of the nickel-containing raw material, an aqueous solution of the cobalt-containing raw material, and the manganese-containing raw material. The ammonium cation-containing complexing agent may be, for example, NH₄OH, (NH₄)₂SO₄, NH₄NO₃, NH₄Cl, CH₃COONH₄, NH₄CO₃ or a combination thereof, but is not limited thereto. Meanwhile, the ammonium cation-containing complexing agent may be used in the form of an aqueous solution. In this case, as the solvent, water or a mixture of an organic solvent that can be uniformly mixed with water (specifically, alcohol, etc.) and water may be used.

The basic compound may be a hydroxide of an alkali metal or alkaline earth metal such as NaOH, KOH or Ca(OH)₂, a hydrate thereof, or a combination thereof. The basic compound may also be used in the form of an aqueous solution. In this case, as the solvent, water or a mixture of an organic solvent that can be uniformly mixed with water (specifically, alcohol, etc.) and water may be used. The basic compound is added to adjust the pH of the reaction solution, and may be added in an amount such that the pH of the metal solution is 11 to 13.

Meanwhile, the co-precipitation reaction may be performed at a temperature of 40 to 70 °C under an inert atmosphere such as nitrogen or argon. By the above process, particles of nickel-cobalt-manganese hydroxide are generated and precipitated in the reaction solution. The precipitated nickel-cobalt-manganese hydroxide particles may be separated according to a conventional method and dried to obtain a nickel-cobalt-manganese precursor. The nickel-cobalt-manganese precursor may be secondary particles formed by agglomeration of primary particles, and the secondary particles of the nickel-cobalt-manganese precursor may have an average particle diameter (D50) of 4 to 8 *µ*m, preferably 4 to 7.5 *µ*m, and more preferably 4 to 7 *µ*m.

The lithium raw material may comprise lithium-containing sulfate, nitrate, acetate, carbonate, oxalate, citrate, halide, hydroxide or oxyhydroxide, and is not particularly limited as long as it can be dissolved in water. Specifically, the lithium source may be Li₂CO₃, LiNO₃, LiNO₂, LiOH, LiOH_{·}H₂O, LiH, LiF, LiCl, LiBr, LiI, CH₃COOLi, Li₂O, Li₂SO₄, CH₃COOLi or Li₃C₆H₅O₇, and any one or a mixture of two or more thereof may be used. The lithium raw material may be mixed so that the molar ratio (Li/M) of lithium (Li) to the total metal element (M) of the nickel-cobalt-manganese precursor is 1 to 1.5, preferably 1 to 1.1.

Next, the positive electrode material for the lithium secondary battery of the present invention prepared through the method of preparing the positive electrode material for the lithium secondary battery will be described. The positive electrode material for the lithium secondary battery according to the present invention comprises a lithium nickel cobalt manganese-based positive electrode active material and a metal oxide layer coated on the surface of the lithium nickel cobalt manganese-based positive electrode active material.

The thickness of the metal oxide layer coated on the surface of the lithium nickel cobalt manganese-based positive electrode active material may be 2 nm or less, preferably 0.8 to 1.5 nm, more preferably 0.8 to 1.2 nm. If the thickness of the metal oxide layer coated on the surface of the lithium nickel cobalt manganese-based positive electrode active material exceeds 2 nm, the film resistance and rate capability characteristics at the beginning of the cycle of the battery including the positive electrode material may be reduced.

In addition, the metal oxide contained in the metal oxide layer has a very high coating uniformity, and for example, is coated on the surface of the lithium nickel cobalt manganese-based positive electrode active material in a metal element ratio of 80 to 88%, preferably 80 to 85%.

In addition, the metal oxide contained in the metal oxide layer may be coated in an amount of 0.05 to 2 parts by weight, preferably 0.08 to 1.2 parts by weight, based on 100 parts by weight of the total weight of the lithium nickel cobalt manganese-based positive electrode active material. If the metal oxide is used in an amount of less than 0.05 parts by weight based on 100 parts by weight of the total weight of the lithium nickel cobalt manganese-based positive electrode active material, the effect of forming the deposition layer may be insignificant, and if it exceeds 2 parts by weight, there may be a problem that the capacity of the battery is reduced.

In addition, the description of the lithium nickel cobalt manganese-based positive electrode active material and the metal oxide constituting the positive electrode material for the lithium secondary battery applies mutatis mutandis as described in the section of the method for preparing the positive electrode material for the lithium secondary battery.

Finally, the lithium secondary battery comprising the positive electrode material for the lithium secondary battery will be described. The lithium secondary battery includes a positive electrode comprising the positive electrode material for the lithium secondary battery, a negative electrode, an electrolyte and a separator interposed between the positive electrode and the negative electrode.

Here, the content of the positive electrode material for the lithium secondary battery may be 50 to 95 parts by weight, preferably 60 to 90 parts by weight based on 100 parts by weight of the positive electrode. If the content of the positive electrode material is less than 50 parts by weight based on 100 parts by weight of the total weight of the positive electrode, the electrochemical properties of the battery by the positive electrode material may be reduced. If the content of the positive electrode material exceeds 95 parts by weight, additional components such as a binder and an electrically conductive material may be included in a small amount, making it difficult to efficiently manufacture a battery.

Meanwhile, the rest of the configuration of the positive electrode except for the positive electrode material, the negative electrode, the electrolyte and the separator may be conventional ones used in the art, and hereinafter, detailed descriptions thereof will be made.

The positive electrode comprised in the lithium secondary battery of the present invention further comprises a binder and an electrically conductive material in addition to the positive electrode active material described above. The binder is a component that assists in the bonding between the positive electrode material (positive electrode active material) and the electrically conductive material and the bonding to a current collector, and for example, may be, but is not limited to, at least one selected from the group consisting of polyvinylidenefluoride (PVdF), polyvinylidenefluoride-polyhexafluoropropylene copolymer (PVdF/HFP), polyvinylacetate, polyvinylalcohol, polyvinylether, polyethylene, polyethyleneoxide, alkylated polyethyleneoxide, polypropylene, polymethyl(meth)acrylate, polyethyl(meth)acrylate, polytetrafluoroethylene (PTFE), polyvinylchloride, polyacrylonitrile, polyvinylpyridine, polyvinylpyrrolidone, styrene-butadiene rubber, acrylonitrile-butadiene rubber, ethylenepropylene-diene monomer (EPDM) rubber, sulfonated EPDM rubber, styrene-butylene rubber, fluorine rubber, carboxymethylcellulose (CMC), starch, hydroxypropyl cellulose, regenerated cellulose, and mixtures thereof.

The binder is usually added in an amount of 1 to 50 parts by weight, preferably 3 to 15 parts by weight, based on 100 parts by weight of the total weight of the positive electrode. If the content of the binder is less than 1 part by weight, the adhesive force between the positive electrode material and the current collector may be insufficient. If the content of the binder is more than 50 parts by weight, the adhesive force is improved but the content of the positive electrode material may be reduced accordingly, thereby lowering the capacity of the battery.

The electrically conductive material comprised in the positive electrode is not particularly limited as long as it does not cause side reactions in the internal environment of the lithium secondary battery and does not cause chemical changes in the battery but has excellent electrical conductivity. The electrically conductive material may typically be graphite or electrically conductive carbon, and may be, for example, but is not limited to, one selected from the group consisting of graphite such as natural graphite or artificial graphite; carbon black such as carbon black, acetylene black, Ketjen black, Denka black, thermal black, channel black, furnace black, and lamp black; carbon-based materials whose crystal structure is graphene or graphite; electrically conductive fibers such as carbon fibers and metal fibers; carbon fluoride; metal powders such as aluminum and nickel powder; electrically conductive whiskers such as zinc oxide and potassium titanate; electrically conductive oxides such as titanium oxide; electrically conductive polymers such as polyphenylene derivatives; and a mixture of two or more thereof.

The electrically conductive material is typically added in an amount of 0.5 to 50 parts by weight, preferably 1 to 30 parts by weight based on 100 parts by weight of total weight of the positive electrode. If the content of electrically conductive material is too low, that is, if it is less than 0.5 parts by weight, it is difficult to obtain an effect on the improvement of the electrical conductivity, or the electrochemical characteristics of the battery may be deteriorated. If the content of the electrically conductive material exceeds 50 parts by weight, that is, if it is too much, the amount of positive electrode material is relatively small and thus capacity and energy density may be lowered. The method of incorporating the electrically conductive material into the positive electrode is not particularly limited, and conventional methods known in the related art such as coating on the positive electrode material can be used. Also, if necessary, the addition of the second coating layer with electrical conductivity to the positive electrode material may replace the addition of the electrically conductive material as described above.

In addition, a filler may be selectively added to the positive electrode of the present invention as a component for inhibiting the expansion of the positive electrode. Such a filler is not particularly limited as long as it can inhibit the expansion of the electrode without causing chemical changes in the battery, and examples thereof may comprise olefinic polymers such as polyethylene and polypropylene; fibrous materials such as glass fibers and carbon fibers; and the like.

The positive electrode material, the binder, the electrically conductive material and the like are dispersed and mixed in a dispersion medium (solvent) to form a slurry, and the slurry can be applied onto the positive electrode current collector, followed by drying and rolling it to prepare a positive electrode of the present invention. The dispersion medium may be, but is not limited to, N-methyl-2-pyrrolidone (NMP), dimethyl formamide (DMF), dimethyl sulfoxide (DMSO), ethanol, isopropanol, water, or a mixture thereof.

The positive electrode current collector may be, but is not limited to, platinum (Pt), gold (Au), palladium (Pd), iridium (Ir), silver (Ag), ruthenium (Ru), nickel (Ni), stainless steel (STS), aluminum (Al), molybdenum (Mo), chromium (Cr), carbon (C), titanium (Ti), tungsten (W), ITO (In doped SnO₂), FTO (F doped SnO₂), or an alloy thereof, or aluminum (Al) or stainless steel whose surface is treated with carbon (C), nickel (Ni), titanium (Ti) or silver (Ag) or so on. The shape of the positive electrode current collector may be in the form of a foil, film, sheet, punched form, porous body, foam, or the like.

The negative electrode may be manufactured according to a conventional method known in the art. For example, the negative electrode active material, the electrically conductive material, the binder, and if required the filler and the like are dispersed and mixed in a dispersion medium (solvent) to form a slurry, and the slurry can be applied onto the negative electrode current collector, followed by drying and rolling it to prepare a negative electrode. As the negative electrode active material, a compound capable of reversible intercalation and deintercalation of lithium may be used. Specific examples thereof may comprise carbonaceous materials such as artificial graphite, natural graphite, graphitized carbon fiber, and amorphous carbon; metallic compounds capable of alloying with lithium, such as Si, Al, Sn, Pb, Sb, Zn, Bi, In, Mg, Ga, Cd, Si alloy, Sn alloy, or Al alloy; metal oxides capable of doping and de-doping lithium, such as SiO_{β}(0 < β < 2), SnO₂, vanadium oxide, and lithium vanadium oxide; or composites comprising the metallic compound and carbonaceous material such as Si-C composite or Sn-C composite, and one of these or a mixture of two or more thereof may be used. In addition, a metallic lithium thin film may be used as the negative electrode active material. In addition, as the carbon material, both low crystalline carbon and high crystalline carbon may be used. The low crystalline carbon is typically soft carbon and hard carbon, and the high crystalline carbon is typically amorphous, plate-like, flaky, spherical or fibrous natural or artificial graphite, Kish graphite, pyrolytic carbon, mesophase pitch-based carbon fiber, meso-carbon microbeads, Mesophase pitches and high-temperature calcined carbon such as petroleum or coal tar pitch derived cokes.

In addition, the binder and the electrically conductive material used for the negative electrode may be the same as those described above for the positive electrode. The negative electrode current collector may be, but is not limited to, platinum (Pt), gold (Au), palladium (Pd), iridium (Ir), silver (Ag), ruthenium (Ru), nickel (Ni), stainless steel (STS), copper (Cu), molybdenum (Mo), chromium (Cr), carbon (C), titanium (Ti), tungsten (W), ITO (In doped SnO₂), FTO (F doped SnO₂), or an alloy thereof, or copper (Cu) or stainless steel whose surface was treated with carbon (C), nickel (Ni), titanium (Ti) or silver (Ag) or so on. The shape of the negative electrode current collector may be in the form of a foil, film, sheet, punched form, porous body, foam or the like.

The separator is interposed between the positive electrode and the negative electrode to prevent a short circuit therebetween and serves to provide a passage for the movement of lithium ions. As the separator, olefin-based polymers such as polyethylene and polypropylene, glass fibers, etc. may be used in the form of a sheet, a multi-membrane, a microporous film, a woven fabric or a non-woven fabric, but are not limited thereto. However, it may be preferable to apply a porous polyethylene or a porous glass fiber nonwoven fabric (glass filter) as a separator, and it may be more preferable to apply a porous glass filter (glass fiber nonwoven fabric) as a separator.

Meanwhile, when a solid electrolyte such as a polymer (e.g., organic solid electrolyte, inorganic solid electrolyte, etc.) is used as the electrolyte, the solid electrolyte may also serve as a separator. Specifically, an insulating thin film having high ion permeability and mechanical strength is used. The separator may generally have a pore diameter of 0.01 to 10 ,um, and a thickness of 5 to 300 *µ*m, but is not limited thereto.

The electrolyte or electrolyte solution is a non-aqueous electrolyte solution (non-aqueous organic solvent), and carbonate, ester, ether, or ketone may be used alone or in combination of two or more, but is not limited thereto. For example, aprotic organic solvents such as dimethyl carbonate, diethyl carbonate, dipropyl carbonate, methylpropyl carbonate, ethylpropyl carbonate, methylethyl carbonate, ethylene carbonate, propylene carbonate, butylene carbonate, γ-butylolactone, n-methyl acetate, n-ethyl acetate, n-propyl acetate, phosphoric acid triester, dibutyl ether, N-methyl-2-pyrrolidinone, 1,2-dimethoxy ethane, tetrahydrofuran derivatives such as 2-methyl tetrahydrofuran, dimethyl sulfoxide, formamide, dimethylformamide, dioxolone and derivatives thereof, acetonitrile, nitromethane, methyl formate, methyl acetate, trimethoxy methane, sulfolane, methyl sulfolane, 1,3-dimethyl-2-imidazolidinone, methyl propionate, ethyl propionate may be used, but is not limited thereto.

A lithium salt may be further added to the electrolyte solution (so-called, a non-aqueous electrolyte solution containing a lithium salt), and the lithium salt may be a well-known one that is easily dissolved in a non-aqueous electrolyte solution, for example, LiCl, LiBr, LiI, LiClO₄, LiBF₄, LiB₁₀Cl₁₀, LiPF₆, LiCF₃SO₃, LiCF₃CO₂, LiAsF₆, LiSbF₆, LiPF₃(CF₂CF₃)₃, LiAlCl₄, CH₃SO₃Li, CF₃SO₃Li, (CF₃SO₂)₂NLi, lithium chloroborane, lithium lower aliphatic carboxylic acid, lithium 4-phenyl borate, lithium imide, and the like, but are not limited thereto. To the (non-aqueous) electrolyte solution, for example, pyridine, triethylphosphite, triethanolamine, cyclic ether, ethylene diamine, glyme-based compound, hexaphosphoric acid triamide, nitrobenzene derivative, sulfur, quinone imine dye, N-substituted oxazolidinone, N,N-substituted imidazolidine, ethylene glycol dialkyl ether, ammonium salt, pyrrole, 2-methoxy ethanol, aluminum trichloride, and the like may be added for the purpose of improving charging/discharging characteristics, flame retardancy and the like. If necessary, a halogen-containing solvent such as carbon tetrachloride or ethylene trifluoride may be further added to impart non-flammability, or carbon dioxide gas may be further added to improve high-temperature storage characteristics.

Meanwhile, the lithium secondary battery of the present invention may be manufactured according to a conventional method in the art. For example, the lithium secondary battery can be manufactured by placing a porous separator between the positive electrode and the negative electrode and adding a non-aqueous electrolyte solution. The lithium secondary battery according to the present invention can be applied to a battery cell used as a power source for a small device and also can be particularly and suitably used as a unit cell of a battery module, which is a power source for medium and large-sized devices. In this aspect, the present invention also provides a battery module comprising two or more lithium secondary batteries electrically connected (series or parallel). Of course, the quantity of lithium secondary batteries comprised in the battery module may be variously adjusted in consideration of the use and capacity of the battery module.

Furthermore, the present invention provides a battery pack in which the battery modules are electrically connected according to a conventional technique in the art. The battery module and the battery pack may be used as a power source for any one or more medium and large-sized devices among a power tool; electric vehicles including electric vehicle (EV), a hybrid electric vehicle (HEV), and a plug-in hybrid electric vehicle (PHEV); electric truck; electric commercial vehicles or power storage systems, but are not limited thereto.

Hereinafter, preferred Examples are presented to help the understanding of the present invention. However, it will be apparent to those skilled in the art that following Examples are merely illustrative of the present invention, and various changes and modifications are possible within the scope and spirit of the present invention, and it goes without saying that such changes and modifications fall within the scope of the appended claims.

### [Example 1] Preparation of positive electrode material for lithium secondary battery

First, in a batch-type 40L reactor set at 50 °C, NiSO₄, CoSO₄, and MnSO₄ were mixed in water in an amount such that the molar ratio of nickel:cobalt:manganese was 80:10:10, thereby preparing a precursor forming solution having a concentration of 2.4M. After charging 13 liters of deionized water in the co-precipitation reactor (capacity of 40 L), nitrogen gas was purged into the reactor at a rate of 25 liters/min to remove dissolved oxygen in the water, and a non-oxidizing atmosphere was created in the reactor. Thereafter, 83 g of a 25% NaOH aqueous solution was added, and the mixture was stirred at a temperature of 50 °C at a speed of 700 rpm to maintain a pH of 11.5. Thereafter, the precursor-forming solution was added at a rate of 1.9 L/hr, respectively, and while adding NaOH aqueous solution and NH₄OH aqueous solution together, the co-precipitation reaction was performed for 48 hours to form particles of nickel-cobalt-manganese-containing hydroxide (Ni_{0.5}Co_{0.3}Mn_{0.2}(OH)₂). The hydroxide particles were separated, washed and dried in an oven at 120 °C to prepare a nickel-cobalt-manganese precursor (D50=4.8 *µ*m).

Subsequently, the prepared nickel-cobalt-manganese precursor and the lithium source of LiOH were put into a Henschel mixer (20L) so that the molar ratio of Li/M (Ni, Co, Mn) is 1.02, and was mixed at center 300 rpm for 20 minutes. The mixed powder was placed in an alumina crucible having a size of 330 mm × 330 mm, and calcined at 1010 to 1030 °C under oxygen atmosphere for 15 hours to prepare a lithium nickel cobalt manganese-based positive electrode active material.

Subsequently, while supplying and stirring 100 g of the prepared lithium nickel cobalt manganese-based positive electrode active material to a chemical vapor deposition apparatus, 1 g of trimethylaluminum (TMA, a metal oxide precursor) was supplied, and at the same time, argon gas as a carrier gas was injected to prepare a positive electrode material for a lithium secondary battery of the present invention in which the metal oxide is coated on the surface of the lithium nickel cobalt manganese-based positive electrode active material. Meanwhile, the temperature inside the deposition apparatus was set to 60 °C, and the carrier gas was injected for 60 minutes after trimethylaluminum was supplied. In addition, FIG. 1 is a schematic diagram of the deposition apparatus used to manufacture the positive electrode material for the lithium secondary battery of the present invention. A in FIG. 1 is a carrier gas injection part, B in FIG. 1 is a carrier gas outlet, and C in FIG. 1 schematically shows the position of the agitator, and the agitator may be located at the bottom of the deposition apparatus.

### [Comparative Example 1] Preparation of positive electrode material of lithium secondary battery

A positive electrode material for a lithium secondary battery was prepared in the same manner as in Example 1, except that argon gas, which is a carrier gas, was not used.

### [Comparative Example 2] Preparation of positive electrode material of lithium secondary battery

A positive electrode material for a lithium secondary battery was prepared in the same manner as in Example 1, except that the stirring process is excluded.

### [Comparative Example 3] Preparation of positive electrode material of lithium secondary battery

A positive electrode material for a lithium secondary battery was prepared in the same manner as in Example 1, except that argon gas which is a carrier gas is not used, and the stirring process is excluded.

### [Comparative Example 4] Preparation of positive electrode material of lithium secondary battery

Trimethylaluminum (metal oxide precursor, 1 g) was coated on the surface of the lithium nickel cobalt manganese-based positive electrode active material (100 g) prepared in Example 1 by an electron beam coating device (i.e., using a physical vapor deposition method rather than a chemical vapor deposition method) to prepare a positive electrode material for a lithium secondary battery in which the metal oxide is coated on the surface of the lithium nickel cobalt manganese-based positive electrode active material. At this time, in the electron beam coating apparatus, the bar on the upper part of the rotating part is rotated so that the raw materials can be uniformly mixed during coating.

### [Experimental Example 1] Evaluation of the content of metal coating in the positive electrode material

For the positive electrode materials prepared in Example 1 and Comparative Examples 1 to 4, respectively, the weight of metal (Al) in the metal oxide (Al₂O₃) located on the surface of the lithium nickel cobalt manganese-based positive electrode active material was measured, and the results are shown in Table 1 below. Meanwhile, the weight of the metal was measured through ICP-OES analysis (inductively coupled plasma spectroscopy).

**Table 1:**

| | Content of metal in positive electrode material (wt.%) |
|---|---|
| Example 1 | 0.51 |
| Comparative Example 1 | 0.43 |
| Comparative Example 2 | 0.40 |
| Comparative Example 3 | 0.36 |
| Comparative Example 4 | 0.13 |

As described above, as a result of measuring the weight of metal (Al) in metal oxide (Al₂O₃) located on the surface of lithium nickel cobalt manganese-based positive electrode active material, it was confirmed, as shown in Table 1 above, that the positive electrode material of Example 1, in which the lithium nickel cobalt manganese-based positive electrode active material was supplied and at the same time, stirring was continuously performed, and argon gas (carrier gas) was supplied along with a metal oxide precursor, has a high metal content, as compared to the positive electrode material of Comparative Example 1 in which no carrier gas was flowed, the positive electrode material of Comparative Example 2 in which no stirring was performed after the supply of the positive electrode active material, and the positive electrode material of Comparative Example 3, in which no carrier gas was flowed and no stirring was performed after the supply of the positive electrode active material. In particular, it can be seen that the positive electrode material of Example 1 using the chemical vapor deposition method has a significantly higher metal content, as compared to the positive electrode material of Comparative Example 4 using the physical vapor deposition method.

Through this, it can be seen that even if the lithium nickel cobalt manganese-based positive electrode active material and the metal oxide precursor are used identically, If the chemical vapor deposition process of the present invention and, in addition, the stirring process after the supply of the positive electrode active material is excluded, the metal oxide coating layer is not normally formed.

### [Experimental Example 2] Evaluation of the ratio of metal element on the surface of the positive electrode material

For the positive electrode materials prepared in Example 1 and Comparative Examples 1 to 4, respectively, the element ratio of metal (Al) in metal oxide (Al₂O₃) located on the surface of lithium nickel cobalt manganese-based positive electrode active material was measured, and the results are shown in Table 2 below. Meanwhile, the ratio of the metal element was measured through Auger Electron Spectroscopy (AES) analysis.

**Table 2:**

| | Elemental ratio of metal (Al) in the positive electrode material (%) |
|---|---|
| Example 1 | 85 |
| Comparative Example 1 | 78 |
| Comparative Example 2 | 69 |
| Comparative Example 3 | 59 |
| Comparative Example 4 | 10 |

As described above, as a result of measuring the element ratio of metal (Al) in metal oxide (Al₂O₃) located on the surface of the lithium nickel cobalt manganese-based positive electrode active material, Example 1, in which deposition was performed while stirring the positive electrode active material with the supply of argon gas, had the highest content of deposits on the surface of the active material. On the other hand, in the case (Comparative Examples 1 and 2) where only one of the supplying of carrier gas and the stirring of the active material was applied, and the case of Comparative Example 3 where neither the supply of carrier gas nor stirring of the active material was carried out, the content of the deposit was significantly lower than in Example 1. In particular, Comparative Example 4, in which the physical vapor deposition method is used, showed a very small amount of deposits compared to Example 1 in which the chemical vapor deposition method is used. Through this, it was confirmed that it is advantageous in terms of yield and density of deposition only when both injection of the carrier gas and stirring of the active material are performed while using the chemical vapor deposition method.

### [Example 2 and Comparative Examples 5 to 8] Manufacture of lithium secondary battery

The positive electrode materials prepared in Example 1 and Comparative Examples 1 to 4, respectively, carbon black as an electrically conductive material and polyvinylidene fluoride (PVdF) as a binder are mixed in a weight ratio of 96.5 : 1.5 : 2, and dispersed in an NMP solvent to prepare a slurry, and then the slurry was coated with a uniform thickness on aluminum foil (Al foil) having a thickness of 25 *µ*m by a Mathis coater (Labdryer/coater type LTE, Werner Mathis AG company), which is a blade-type coating machine, and dried in a vacuum oven at 120 °C for 13 hours to prepare a positive electrode for a lithium secondary battery.

Then, after positioning the prepared positive electrode to face the negative electrode (Li metal foil), a porous polyethylene separator was interposed therebetween to prepare an electrode assembly, and after placing the electrode assembly inside the case, an electrolyte solution was injected into the case to prepare a half-cell lithium secondary battery. At this time, the electrolyte solution was prepared by dissolving a trace amount of vinylene carbonate (VC) in an organic solvent obtained by mixing ethylene carbonate, ethylmethyl carbonate, and diethyl carbonate in a volume ratio of 1:2:1.

### [Experimental Example 3] Evaluation of charging/discharging capacity and coulombic efficiency of lithium secondary battery

First, for the lithium secondary batteries prepared in Example 2 and Comparative Examples 5 to 8, 30 times of charging and discharging were performed by charging at CCCV mode at room temperature and 0.2C to 4.4V and then discharging at a constant current of 0.2C to 3.0V. The charging capacity, discharging capacity, and coulombic efficiency in the first cycle were measured, respectively, and the results are shown in Table 3 below.

**Table 3:**

| | Charging capacity (mAh/g) | Discharging capacity (mAh/g) | Coulombic efficiency (%) |
|---|---|---|---|
| Example 2 | 226.0 | 208.8 | 92.4 |
| Comparative Example 5 | 227.3 | 208.6 | 91.8 |
| Comparative Example 6 | 227.6 | 208.3 | 91.5 |
| Comparative Example 7 | 228.5 | 207.5 | 90.8 |
| Comparative Example 8 | 229.7 | 207.5 | 90.3 |

As described above, as a result of measuring the charging capacity, discharging capacity, and coulombic efficiency by charging and discharging the lithium secondary batteries prepared in Example 2 and Comparative Examples 5 to 8, respectively, it was confirmed, as shown in Table 3, that the battery of Example 2 comprising the positive electrode material manufactured by supplying the lithium nickel cobalt manganese-based positive electrode active material while continuously stirring, and supplying argon gas (carrier gas) with the metal oxide precursor to it had excellent coulombic efficiency, as compared to the battery of Comparative Example 5 comprising the positive electrode material prepared without flowing carrier gas, the battery of Comparative Example 6 comprising the positive electrode material prepared without stirring after supply of the positive electrode active material, the battery of Comparative Example 7 comprising a positive electrode material prepared without flowing a carrier gas and without stirring after supplying the positive electrode active material, and the battery of Comparative Example 8 comprising the positive electrode material prepared using a physical vapor deposition method (in particular, the battery of Comparative Example 8 had a large charging capacity and low coulombic efficiency due to a side reaction of the electrolyte during charging).

Through this, it was found that if the metal oxide is normally coated on the surface of the lithium nickel cobalt manganese-based positive electrode active material (that is, if not coated thinly and evenly), it is impossible to maintain high capacity of the battery, and from this, it can be seen that the metal oxide was formed thinly and uniformly on the surface of the lithium nickel cobalt manganese-based positive electrode active material, suppressing side reactions at the interface in contact with the electrolyte during the operation of the battery (during charging).

### [Experimental Example 4] Evaluation of lifetime of lithium secondary battery

First, for the lithium secondary batteries prepared in Example 2 and Comparative Examples 5 to 8, 30 times of charging and discharging were performed by charging at CCCV mode at room temperature and 0.2C to 4.4V and then discharging at a constant current of 0.2C to 3.0V. The retention rate of discharging capacity relative to the first cycle after 30 times of charging and discharging was measured, respectively, and the results are shown in Table 4 below.

**Table 4:**

| | Discharging capacity retention rate (%) |
|---|---|
| Example 2 | 96.0 |
| Comparative Example 5 | 94.9 |
| Comparative Example 6 | 94.5 |
| Comparative Example 7 | 93.0 |
| Comparative Example 8 | 91.9 |

As described above, as a result of measuring the retention rate of discharging capacity relative to the first cycle after 30 times of charging and discharging for the lithium secondary batteries prepared in Example 2 and Comparative Examples 5 to 8, it can be seen, as shown in Table 4, that the more uniformly and densely the metal oxide is coated on the surface of the lithium nickel cobalt manganese-based positive electrode active material, the more effectively the side reaction at the electrode-electrolyte interface is suppressed, which is beneficial to maintaining the lifetime of the battery.

## Claims

1. A method for preparing a positive electrode material for a lithium secondary battery comprising a method of coating a metal oxide on the surface of a lithium nickel cobalt manganese-based positive electrode active material through chemical vapor deposition, which comprises a step of placing lithium nickel cobalt manganese-based positive electrode active material in a deposition apparatus and supplying a metal oxide precursor and a carrier gas,
wherein the lithium nickel cobalt manganese-based positive electrode active material is stirred during deposition.

2. The method for preparing the positive electrode material for the lithium secondary battery according to claim 1, wherein the carrier gas is supplied to the deposition apparatus at a temperature of 25 to 150 °C.

3. The method for preparing the positive electrode material for the lithium secondary battery according to claim 1, wherein the carrier gas is supplied for 10 to 200 minutes.

4. The method for preparing the positive electrode material for the lithium secondary battery according to claim 1, wherein the carrier gas is argon gas or nitrogen gas.

5. The method for preparing the positive electrode material for the lithium secondary battery according to claim 1, wherein the metal oxide is selected from the group consisting of Al₂O₃, TiO₂, SiO₂, ZrO₂, VO₂, V₂O₅, Nb₂O₅, MgO, TaO₂, Ta₂O₅, B₂O₂, B₄O₃, B₄O₅, ZnO, SnO, HfO₂, Er2O₃, La₂O₃, In₂O₃, Y₂O₃, Ce₂O₃, Sc₂O₃ and W₂O₃.

6. The method for preparing the positive electrode material for the lithium secondary battery according to claim 1, wherein the metal oxide precursor is trimethylaluminum.

7. The method for preparing the positive electrode material for the lithium secondary battery according to claim 1, wherein the stirring is continuously performed during deposition.

8. The method for preparing the positive electrode material for the lithium secondary battery according to claim 1, wherein the lithium nickel cobalt manganese-based positive electrode active material and the metal oxide precursor are supplied to the deposition apparatus in a weight ratio of 100 to 120:1 to 10.

9. The method for preparing the positive electrode material for the lithium secondary battery according to claim 1, wherein the deposition is performed 1 to 4 times.

10. A positive electrode material for a lithium secondary battery comprising a lithium nickel cobalt manganese-based positive electrode active material; and a metal oxide layer coated on the surface of the lithium nickel cobalt manganese-based positive electrode active material.

11. The positive electrode material for the lithium secondary battery according to claim 10, wherein the thickness of the metal oxide layer is 2 nm or less.

12. The positive electrode material for the lithium secondary battery according to claim 10, wherein the metal oxide comprised in the metal oxide layer is coated on the surface of the lithium nickel cobalt manganese-based positive electrode active material in a metal element ratio of 80 to 88%.

13. The positive electrode material for the lithium secondary battery according to claim 10, wherein the metal oxide comprised in the metal oxide layer is coated in an amount of 0.05 to 2 parts by weight based on 100 parts by weight of the total weight of the lithium nickel cobalt manganese-based positive electrode active material.

14. A lithium secondary battery comprising a positive electrode comprising the positive electrode material for the lithium secondary battery of claim 10; a negative electrode; an electrolyte interposed between the positive electrode and the negative electrode; and separator.
